Europäisches Patentamt

European Patent Office

Office européen des brevets

Publication number: **0 287 312**
**A2**

# EUROPEAN PATENT APPLICATION

(21) Application number: 88303247.6

(22) Date of filing: 12.04.88

(51) Int. Cl.⁴ **H03M 1/06 , H03M 1/66**

(30) Priority: 13.04.87 JP 90269/87

(43) Date of publication of application:
**19.10.88 Bulletin 88/42**

(84) Designated Contracting States:
**DE GB**

(71) Applicant: **Matsushita Electric Industrial Co., Ltd.**
**1006, Oaza Kadoma**
**Kadoma-shi Osaka-fu, 571(JP)**

(72) Inventor: **Oinuma, Akira c/o**
**Mat.Elec.Ind.Co.,Ltd.**
**1006, Osaza Kadoma**
**Kadoma-shi, Osaka(JP)**

(74) Representative: **Crawford, Andrew Birkby et al**
**A.A. THORNTON & CO. Northumberland**
**House 303-306 High Holborn**
**London WC1V 7LE(GB)**

(54) **Digital-analog converter.**

(57) The invention relates to a digital-analog converter (DAC), and is designed to prevent fundamentally "zero cross distortion" in the output voltage waveform of DAC or the generation of glitch and to improve the fidelity considerably when reproducing analog signals of minute level in particular, equipped with two DACs, a first DAC and a second DAC, and when reproducing a since wave for example, the digital-analog converter outputs the waveform corresponding to the input digital signal from the first DAC and outputs a certain reference voltage (0V for example) from the second DAC during a reproducing period of a positive half-wave.

Conversely, during a reproducing period of a negative half-wave, a positive waveform of which the input digital signal from the second DAC is inverted is outputted and a certain reference voltage (0V for example) is outputted from the first DAC. As a result of this, the output voltage of both DACs becomes positive or 0V so that the output voltage will not cross zero, and it becomes possible to eliminate "zero corss distortion" and the like.

FIG. 1

# DIGITAL-ANALOG CONVERTER

The present invention relates to a digital-analog converter and is suitable for a digital audio equipment in that harmonic distortion or noise in particular can be reduced.

The digital-analog converter (hereinafter called DAC) is an important constituent element which largely influences the performance of a digital audio equipment, but due to its composition, the DAC is susceptible to the influence of the supply voltage fluctuation, which used to cause the harmonic distortion or modulation distortion of audio signal.

Further, because the DAC is consisted of a number of semiconductor devices, the DAC itself became a noise source causing S/N of the audio signal to deteriorate.

As a means to improve the defect of the DAC as described above, a method which cancels the influence of the supply voltage fluctuation or the influence of noise by causing two DACs to operate with a push-pull has been suggested (Denpa Shimbun, March 13, 1987, Page 13).

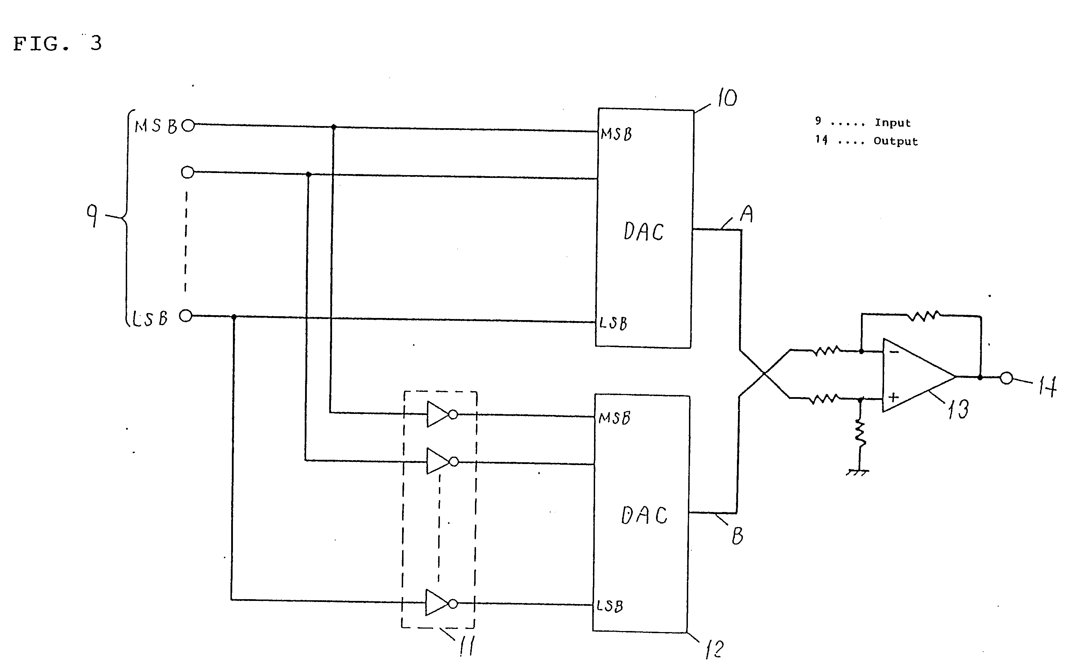

Fig. 3 is a block diagram showing a composition of the aforementioned conventional digital-analog converter, wherein the digital-analog converter operates so as to output the difference of the output voltage between the two DACs, 10, 12, which operate with mutually opposite phases.

An input digital signal 9 is inputted into the DAC 10 on one hand. and in inputted into the DAC 12 through an inverter 11 on the other hand. As a result of this entry, the output voltage of the DAC 10 and the output voltage of the DAC 12 have their phases inverted relatively, and by operating the difference of both DAC by an operational amplifier 13, it is possible to obtain two times the output voltage of each DAC.

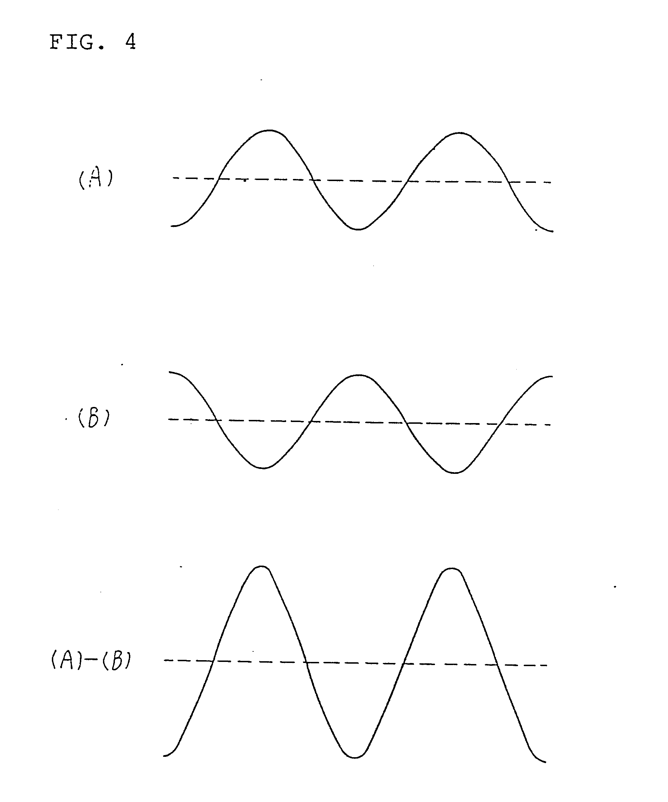

Fig. 4 shows a relation of the output voltage waveform between each DAC in the aforementioned conventional digital-analog converter, in which the waveform A corresponds to the output voltage of the DAC 10 and the waveform B corresponds to the output voltage of the DAC 12. The waveform of A - B is the result of the subtraction of the waveform of A and the waveform of B, and the waveform of A - B becomes the output voltage obtained at the output terminal 14. That is, in the aforementioned example, when a sine wave is outputted, the output voltage waveform of each DAC also becomes the sine wave, so that the digital data to be inputted in either DAC will be inverted of all bits thereof when the waveform crosses zero.

As a result of inverting all bits while the waveform crosses zero, what is called "zero cross distortion" is generated or glich is generated thereby preventing high fidelity reproduction in many cases, but in the aforementioned example, there is no improvement as far as such high fidelity reproduction is concerned. allowing "zero cross distortion" or glich which is generated by each DAC is outputted as it is, and the effect of using two DACs is not so immediate.

## BRIEF SUMMARY OF THE INVENTION

The present invention is designed in view of the above problems so as to prevent fundamentally the generation of "zero cross distortion" or glich in the output voltage waveform of each DAC. and intended to provide a-digital-analog converter which can improve the fidelity considerably when reproducing analog signals of minute level in particular.

In order to solve the above-mentioned problems, the digital-analog converter of the present invention is equipped with a first DAC and a second DAC, an operational amplifier which carries out the addition and subtraction of the output voltage of the aforementioned first DAC and the output voltage of the aforementioned second DAC, when an analog signal of positive polarity is to be converted and outputted, the second DAC outputs a constant reference voltage, and when an analog signal of negative polarity is to be converted and outputted, the first DAC outputs a constant reference voltage.

The functions of the DAC of the present invention according to the aforementioned composition will be described as follows.

That is, when reproducing a sine waveform for example, during a period wherein the positive half-wave is to be reproduced, a waveform corresponding to an input digital signal is outputted from the first DAC, and a constant reference voltage (0V for example) is outputted from the second DAC. Conversely, during a period wherein the negative half-wave is to be reproduced, the positive sine waveform which is inverted of an input digital signal is outputted from the second DAC, and a constant reference voltage (0V for example) is outputted from the first DAC. Consequently, the output voltage of either DAC becomes positive or 0V and will not cross zero, and it becomes possible to eliminate "zero cross distortion" and the like.

## DETAILED DESCRIPTION

Embodiments of the present invention will hereinafter be described with reference to the drawings.

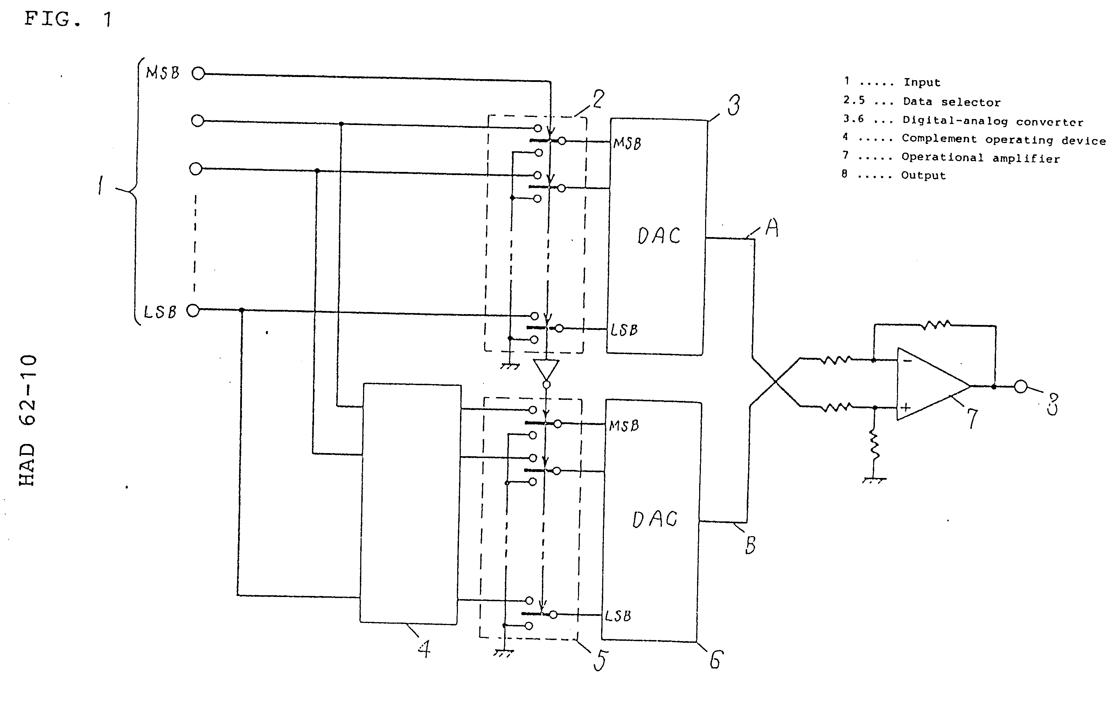

Fig. 1 is a circuit diagram showing a composition of an embodiment of the present invention.

In the diagram, the most significant bit of the input digital signal 1 is used as the positive/negative judgement signal to change an input digital signal to each DAC according to the positive state or the negative state of the polarity. The first data selector 2 is used to change the input digital signal of the first DAC 3, and operates so that when the input digital signal 1 is positive, the input digital signal from the second bit thereof to the least significant bit thereof are inputted into the first DAC 3, when the input digital signal is negative, "0" is inputted into all bits. The input digital signal 1 is converted into complement data by the complement operating device 4 to be inputted into the second data selector 5. The second data selector 5 is used to change the input digital signal of the second DAC 6, and operates so that when the input digital signal 1 is negative, complement of the input digital signal from the second bit thereof up to the least significant bit thereof is inputted into the second DAC 6, and when the input digital signal 1 is positive, "0" is inputted into all bits. The output voltage of each DAC is subtracted by the operational amplifier 7 and outputted at the output terminal 8.

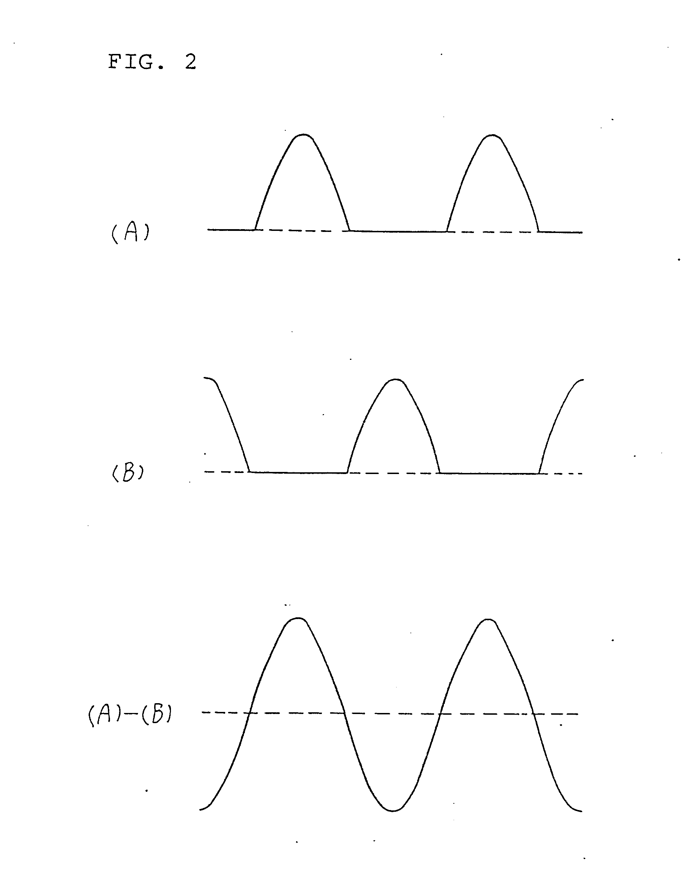

Fig. 2 shows the relation of the output voltage waveform between each DAC in the aforementioned embodiment, in which the waveform A corresponds to the output voltage of the first DAC 3 and the waveform B corresponds to the output voltage of the second DAC 6. The waveform of A - B is the result of the subtraction of the waveform of A and the waveform of B, and the waveform of A - B becomes the waveform obtained at the output terminal 8. As can be known from Fig. 2, each DAC is operating in a positive (or 0) range and will not be operating in a negative range. That is, each DAC will not cross zero and there will be no what is called "zero cross distortion" to be generated. When the output waveform starts rising gradually from zero, input digital signal is changed in order from the lower bit, and as in the case of a conventional example, there is no possibility that all bits are inverted simultaneously. For this reason, it is difficult for glitch to be generated fundamentally, and a separate deglitch circuit is not necessary. As regards each DAC, because only the positive (or 0) output is required always, what is called the unipolar operation will suffice and it is not necessary to have bipolar operation as in the case of the conventional example.

As described above, the digital-analog converter of the present invention is equipped with a first DAC and a second DAC, an operational amplifier which carries out the addition and subtraction of the output voltage of the aforementioned first DAC and the output voltage of the aforementioned second DAC, when an analog signal of positive polarity is to be converted and outputted, and second DAC outputs a constant reference voltage, and when an analog signal of negative polarity is to be converted and outputted, the first DAC outputs a constant reference voltage. Therefore, the output voltage of each DAC is always positive (or 0) and there is no possibility of crossing zero. For this reason, what is called "zero cross distortion" will not be generated and the analog signal is changed in order from the lower bit in a minute signal level, and there is an effect the glich is difficult to be generated. Consequently, a high fidelity digital-analog converter is provided which is suitable for a digital audio equipment in which the distortion at a minute signal level in particular or noise becomes problematic.

BRIEF DESCRIPTION OF THE DRAWING.

Fig. 1 is a circuit diagram showing the digital-analog converter of an embodiment of the present invention, Fig. 2 is a waveform diagram showing the relation of the output voltage waveform between each DAC in the above embodiment, Fig. 3 is a circuit diagram showing an example of the composition of a conventional digital-analog converter, and Fig. 4 is a waveform diagram showing the relation of the output voltage waveform between each DAC in the above conventional example.

**Claims**

(1) A digital-analog converter comprising a first digital-analog converter and a second digital-analog converter, an operational amplifier which carries out the addition and subtraction of the output voltage of the above first digital-analog converter and the above second digital-analog converter, when the analog signal of positive polarity is to be converted and outputted, the second digital-analog converter outputs a constant reference voltage, and when the analog signal of negative polarity is to be converted and outputted, the first digital-analog converter outputs a constant reference voltage.

(2) A digital-analog converter according to claim 1, wherein when the analog signal of positive polarity is to be converted and outputted, "0" is inputted into all bits of the second digital-analog converter by the second data selector to cause a constant reference voltage to be outputted, and when the analog signal of negative polarity is to be converted and outputted, "0" is inputted into all bits of the first digital-analog converter by the first data selector to cause a constant reference voltage to be outputted.

(3) A digital-analog converter according to claim 2, wherein when the analog signal of negative polarity is to be converted and outputted, complement data is inputted into the second digital-analog converter.

FIG. 1

0 287 312

HAD 62-10

1 ..... Input
2.5 ... Data selector
3.6 ... Digital-analog converter
4 ..... Complement operating device
7 ..... Operational amplifier
8 ..... Output

FIG. 2

(A)

(B)

(A)−(B)

FIG. 3

9 ..... Input
14 ..... Output

FIG. 4

(A)

(B)

(A)−(B)